# EUROPEAN PATENT SPECIFICATION

(11) **EP 1 898 523 B1**
(45) Date of publication and mention of the grant of the patent: **04.07.2012**
(21) Application number: 06291418.9
(22) Date of filing: 05.09.2006
(51) Int. Cl.: H03F 3/72, H03F 3/60, H03F 1/56, H03F 1/02, H03F 3/24, H01P 5/12, H01P 5/04

(54) **Switchable power divider circuit and power amplifier module**
Schaltbarer Leistungsteiler und Leistungsverstärkermodul
Diviseur de puissance commutable et module amplificateur de puissance

(43) Date of publication of application: 12.03.2008
(73) Proprietor: Alcatel Lucent, 75007 Paris (FR)
(72) Inventor: Wiegner, Dirk, 71409 Schwaikheim (DE); Nass, Tobias, 70435 Stuttgart/Zuffenhausen (DE)
(74) Representative: Wetzel, Emmanuelle

(56) References cited:
- EP-A- 1 515 390
- WO-A-02/23757
- JP-A- 10 233 601
- US-A1- 2003 001 668

## Description

### Background of the invention

The present invention relates to a power divider circuit for a power amplifier module comprising:
- a first port;
- at least one first circuit branch connecting said first port with a second port;
- at least one second circuit branch connecting said first port with a third port.

The present invention also relates to a power amplifier module comprising at least two amplifying means.

The present invention further relates to a transmitter for multi-standard transmission, a base station for multi-standard communication, and a mobile station for multi-standard communication.

In multi-standard radio frequency (RF) applications, different communication standards, e.g., GSM, EDGE, UMTS, etc., have to be addressed by only one amplifier module within a common frequency band. Depending on a desired range of coverage (medium-/wide-range), the load situation of a base station in a communication network (which may depend on the time of day), and also on the addressed communication standard, different peak output power levels are required. This is particularly true for the above-mentioned GSM, EDGE, and UMTS operation of a multi-standard base station and mobile terminals capable of multi-standard transmission, since they have to cover the above-mentioned needs for peak output power adaptation by means of only one (single) power amplifier module.

Additionally, amplifier efficiency is a main issue in connection with power amplifier modules for modern base stations and mobile terminals due to increased requirements of linearity, which are associated with new complex modulation schemes devised to meet an always increasing demand for higher data rates.

As already mentioned above, the term "multi-standard" generally refers to covering different communication standards, in particular within the same frequency band. This leads to different required peak output power levels in connection with different communication signals used in connection with said communication standards. The following table provides an overview of an exemplary multi-standard situation:

| *Standard* | *Peak-to-average-ratio* | *Required average output power* | *Necessary peak output power* |
|---|---|---|---|
| GSM | 0 dB | 65 W | 65 W |
| EDGE | 3.3 dB | 65 W | 140 W |
| UMTS | 6 dB (clipped) | 50 W | 200 W |

Additionally, in case of UMTS, the users of mobile communication have to share the power transmitted by a base station or base transceiver station (BTS). Therefore, as stated above, the required output power is dependent on the time of day, since more users have access to a given BTS during day time than during night time. Thus, a certain flexibility in output power adjustment is required in order to improve overall efficiency of a BTS. Said output power adjustment flexibility will also enable to use a BTS either as micro BTS or macro BTS with different ranges of coverage.

A prior art approach to the above-described situation of providing adjustable output power is based on stage-bypassing. This means that a plurality of amplifier stages are provided within a multi-standard amplifier module and that a number of amplifier stages are bypassed in order to deliver a predefined (i.e., reduced) output power level. Said approach suffers from limited flexibility and limited power amplifying efficiency. Another power divider circuit of the prior art is given by document EP-A-1515390.

### Object of the invention

It is the object of the present invention to provide a power divider circuit and a power amplifier module of the above-defined type which enable to deliver adjustable peak output power levels with increased flexibility and power amplifying efficiency.

### Summary of the invention

According to a first aspect of the present invention the object is achieved by providing a power divider circuit as defined in claim 1.

According to a second aspect of the present invention the object is achieved by providing a power amplifier module of the above-defined type which further comprises at least one power divider circuit according to said first aspect of the present invention, wherein a first one of said amplifying means is connected with said second port of the divider circuit, and wherein a second one of said amplifying means is connected with said third port of the divider circuit.

According to a third aspect of the present invention, the object is achieved by providing a transmitter for multi-standard transmission which comprises at least one amplifier module according to said second aspect of the present invention.

According to a fourth aspect of the present invention the object is achieved by providing a base station for multi-standard communication which comprises at least one transmitter according to said third aspect of the present invention.

According to a fifth aspect of the present invention the object is achieved by providing a mobile station for multi-standard communication which comprises at least one transmitter according to said third aspect of the present invention.

In accordance with a general idea underlying the present invention, the power capability of a final amplifier module used for amplifying signals in multi-standard communication applications has to be variable. In this way, at least two parallel amplifying means, e.g., power transistors, with predefined respective power capabilities are employed. With respect to the required or supported communication standard, at least one of said amplifying means has to be used in a single operation mode, or a number of amplifying means have to operate in parallel. To achieve this, a novel kind of power divider circuit or power divider is proposed.

The proposed power divider comprises at least two output ports, which can be switched on either separately or in parallel (simultaneously), thus enabling to provide, e.g., three different adjustable output power levels by employing only two amplifying means if two output ports are used, as mentioned above.

In a further embodiment of the power divider in accordance with the present invention said switching elements are devised as diodes, in particular PIN (positive intrinsic negative) diodes. Alternatively, said switching elements can be devised in the form of mechanical or electro-mechanical switches, e.g., relays or the like, as long as said switching elements enable to activate/deactivate the respective branches of the proposed power divider. Said power divider can thus be referred to as a switchable power divider.

In a further embodiment of the power divider in accordance with the present invention each switching element is further connected with a respective blocking element, in particular a capacitor, for blocking a biasing potential of said switching element. In particular, said blocking elements are needed in case the switching elements are devised as diodes in order to block a diode biasing potential.

In a further embodiment of the power divider in accordance with the present invention each one of said first and second circuit branches and said first and second bypass branches comprises at least one phase-shifting means, in particular a quarter-wave transformer. As will be appreciated by a person skilled in the art, with respect to said first and second circuit branches the proposed power divider is therefore devised in the form of a conventional Wilkinson power divider. However, as also known to a person skilled in the art, if an input power provided at said first port is to be delivered to only one of the second and third ports of a conventional Wilkinson divider, the latter causes an insertion loss of 3 dB (for the exemplary case of a symmetrical divider). In contrast to this, the proposed switchable power divider circuit extends the conventional Wilkinson divider principle to providing the totality of input power to a single output port via one of said bypass branches without said 3 dB loss.

For to obviate the potentially negative effect of impedance mismatching at a switching node of the proposed switchable power divider circuit, in yet another embodiment of the power divider in accordance with the present invention each one of said first and second circuit branches and said first and second bypass branches comprises a first and a second phase-shifting means, in particular a quarter-wave transformer, wherein the switching element for each branch is connected with a node located between respective first and second phase-shifting means. In this way, parallel use of all output ports is supported, which is an important feature of the switchable power divider circuit in accordance with the present invention.

In yet another embodiment in accordance with the present invention more than one respective switching element (a "switchable short" for blocking an input signal) is provided in operative connection with each of said first and second circuit branches and each of said first and second bypass branches. As a bandwidth of the blocked signal is limited by phase shifting, e.g. quarter-wave transformation, additional switchable shorts (or RF blocks) may increase said bandwidth or may provide for blocking a different (remote) frequency band, e.g. one octave higher.

As already stated above, a preferred field of use of the proposed switchable power divider circuit is for realising a power amplifier module in accordance with said second aspect of the present invention. In this context and in another embodiment of the power amplifier stage in accordance with the present invention the latter further comprises a second power divider circuit according to said first aspect of the present invention, wherein said first one of said amplifying means is further connected with said second port of the second divider circuit, and wherein said second one of said amplifying means is further connected with said third port of the second divider circuit. Thus, said second power divider effectively functions as a power combiner.

In this way, the above-described approach offers a cost-effective solution for adjusting/providing a required output power level for each addressed communication standard within a common frequency band and/or in relation to a required range of coverage and/or in reaction to a changing degree of utilisation. Simultaneously, an improved efficiency of multi-standard power amplifier modules can be achieved.

As will be appreciated by a person skilled in the art, said improved efficiency has been demonstrated to cover a frequency range of, e.g., 300 MHz by simulation, as will be described in detail farther down.

Further advantages and characteristics of the present invention can be gathered from the following description of preferred embodiments given by way of example only with reference to the enclosed drawings. The described embodiments are not to be regarded as an exhaustive enumeration but rather as examples with respect to a basic concept underlying the present invention.

### Brief description of the drawings

- Fig. 1: is a circuit diagram of an embodiment of the switchable power divider circuit in accordance with the present invention;
- Fig. 2: is a block diagram of an embodiment of the power amplifier module in accordance with the present invention; and
- Fig. 3: is a diagram showing the behaviour of a multi-standard power amplifier comprising the amplifier module of Fig. 2.

### Detailed description

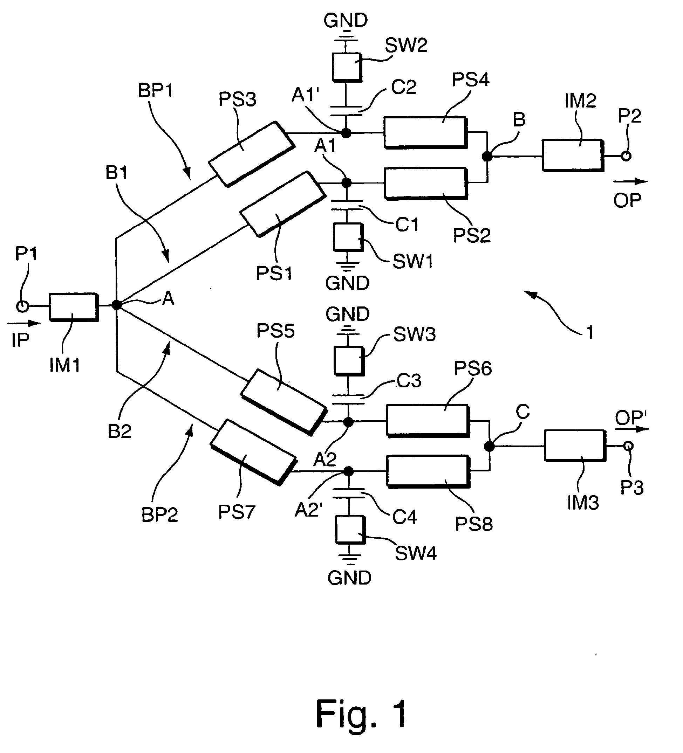

**Fig. 1** shows a circuit diagram of an embodiment of the power divider circuit in accordance with the present invention. The switchable power divider circuit 1 of Fig. 1 comprises a first port **P1,** a second port **P2,** and a third port **P3.** Said first port P1 and said second port P2 are connected by means of a first circuit branch **B1** via nodes **A, A1** and **B**. Said first port P1 and said third port P3 are connected by means of second circuit branch **B2** via nodes A, **A2** and **C**.

In parallel with each of said first and second circuit branches B1, B2, the switchable power divider circuit 1 comprises bypass branches **BP1** and **BP2**, respectively. The first bypass branch BP1 connects said first port P1 with said second port P2 via nodes A, **A1',** and B. Second bypass branch BP2 connects said first port P1 with said third port P3 via nodes A, **A2',** and C.

In this way, node A functions as a common node for all of said first and second circuit branches B1, B2 and said first and second bypass branches BP1, BP2. Between said common node A and said node B, each of the first circuit branch B1 and the first bypass branch BP1 comprises two quarter-wave transformers **PS1**, **PS2** and **PS3**, **PS4,** respectively, which for each of said branches B1, BP1 are arranged on opposite sides of said node A1 and said node A1', respectively Likewise, each of said second circuit branch B2 and said second bypass branch BP2 comprises two more phase-shifting means **PS5, PS6** and **PS7, PS8,** in the form of quarter-wave transformers. As previously described with respect to said first circuit branch B1 and said first bypass branch BP1, said phase-shifting means PS5, PS6 and PS7, PS8 are arranged on opposite sides of said node A2 and said node A2', respectively.

Between said first port P1 and said common node A, there is provided an impedance matching means **IM1** for matching of port P1 at a predefined impedance Z₀, e.g., Z₀ = 50 Ω. Further impedance matching means **IM2, IM3** are provided between nodes B, C and said second and third ports P2, P3, respectively. Note that said further impedance matching means IM2, IM3 are required only in case that impedance matching has not been achieved by means of said phase-shifting means PS1-PS8.

At node A1, a switching element **SW1** is connected between said first circuit branch B1 and ground potential **GND**. Optionally, particularly in case said switching element SW1 is devised in the form of a diode (e.g., PIN diode), a blocking element in the form of a capacitor **C1** is connected with said first circuit branch B1 at node A1 for blocking an applied biasing potential. Thus, blocking element C1 is connected in series with said switching element SW1 which is connected between said blocking element C1 and ground potential GND. Likewise, at node A1' a series connection of blocking element (capacitor) **C2** and switching element **SW2** is connected between node A1' and ground potential GND. If switching elements SW1, SW2 are devised as (electro-)mechanical switches, e.g. relays or the like, blocking elements C1, C2 can be omitted. On the other hand, if switching elements are devised as (PIN) diodes then said blocking elements C1, C2 are required; they may be provided together with the respective diode and a suitable biasing means in a self-contained switch package (not shown).

In the same way, an (optional) blocking element (capacitor) **C3** and a switching element **SW3** are connected between node A2 on said second circuit branch B2 and ground potential GND, and an (optional) blocking element (capacitor) **C4** and a switching element **SW4** are connected between node A2' on bypass branch BP2 and ground potential GND. If switching elements SW3, SW4 are devised in the form of (electro-)mechanical switches, e.g. relays or the like, said blocking elements C3, C4 can be omitted, as explained in detail above.

In the following, operation of the above-described embodiment of the power divider circuit 1 in accordance with the present invention will be explained in detail with reference to appended Fig. 1:

As will be appreciated by a person skilled in the art, the above-described switchable power divider circuit of Fig. 1 can be operated in a first operation mode and a second operation mode. Hereinafter, said first operation mode will also be referred to as "divider mode", while said second operation mode will also be referred to as "single output mode" or "switching mode".

In said first operation mode, the divider mode, the switchable power divider functions in the same way as a conventional two-stage Wilkinson divider, wherein the conventional crosswise installed resistors can be omitted, if even mode operation is assumed. In said divider mode, an input power **IP** provided at said first port P1 of the switchable power divider circuit 1 is split to both of said second and third ports P2, P3. In order to achieve this, both the first and second bypass lines BP1, BP2 are switched off by closing said switching elements SW2, SW4 provided in operative connection with said first and second bypass branches BP1, BP2, respectively. In this way, said bypass branches BP1, BP2 act as an open at respective nodes A, B, and C. Simultaneously, switching elements SW1 and SW3 provided in operative connection with said first and second circuit branches B1 and B2, respectively, are opened (switched off) so that said first and second circuit branches are active.

In this way, in said first operation mode the inventive switchable power divider circuit functions as a conventional two-stage Wilkinson divider, as known to a person skilled in the art. Line impedances of the divider can be determined with respect to the conventional Wilkinson theory and determine a dividing factor of the switchable power divider circuit (cf. R. E. Collin, "Foundations for Microwave Engineering", IEEE Press, 2001, pp. 442-450). All of said first through third ports P1-P3 in the embodiment of Fig. 1 are matched to reference impedance Z₀.

Preferably, said switching elements SW1-SW4 in the embodiment of Fig. 1 are devised in the form of PIN (Positive Intrinsic Negative) diodes. Respective biasing potentials (not shown) are blocked by blocking elements C1-C4.

However, it should be noted that in case of said switching elements being devised in the form of mechanical or electro-mechanical switches which do not require any biasing potential, in yet another embodiment of the present invention said blocking elements C1-C4 can be omitted.

In this way, output power **OP**, **OP'** can be provided at both of said second and third ports P2 and P3, respectively. In the above-described embodiment of the inventive power divider circuit 1, said output powers OP, OP' delivered at said second port P2 and said third port P3, respectively, are of equal level.

In a second operation mode, the single output mode, input power IP at said first port P1 is delivered either to said second port P2 or to said third port P3 via a single circuit path. For to achieve this, all the other transmission paths departing from said first port P1 are switched off. To enable, e.g., said second port P2, switching elements SW1, SW3, and SW4 are switched on, and switching element SW2 is switched off. Since all other paths except said first bypass branch BP1, which comprises switching element SW2, do act as an open at respective nodes A, B and C, input power IP is completely delivered to said second port P2 via first bypass branch BP1. Bypass branch BP1 transforms the resulting impedance at switching node A to the output reference impedance. In a similar way, to enable said third port P3, switching elements SW1, SW2, and SW3 are switched on, and switching element SW4 is switched off.

As already explained to some extent above, sub-circuits of the inventive switchable power divider circuit, which comprise any one of said nodes A1, A1', A2, A2' connected with a respective pair of quarter-wave transformers as well with a blocking element and a switching element, function as so-called double-sided switchable RF-blocks. Said double-sided switchable RF-blocks function as a switchable short which is transformed in both directions (input and output directions) to act as an open at the input side at A, and at the output side, e.gat B with respect to the first circuit branch B1 and the first bypass branch BP1. In this way, the complete input power can be delivered to only one port in said single output mode. Without said first and second bypass lines BP1, BP2, simply switching off one of said first and second circuit branches B1, B2 or switching off one of said second and third ports P2, P3 would cause impedance mismatching at the switching node, so that input power could not be completely delivered to the load at a respective active (output) port.

A further advantage of the embodiment according to Fig. 1 resides in the fact that owing to the above-described two-stage quarter-wave line sections (in the first and second circuit branches B1, B2 and in the first and second bypass branches BP1, BP2, respectively), which are needed to realise said two-sided switchable RF-blocks, the proposed solution offers an intrinsic compatibility with broadband signals.

As will be appreciated by a person skilled in the art, the above-described working principle can also be adapted to switchable power divider circuits having more than only two parallel circuit branches (and a corresponding number of parallel bypass branches), wherein - in accordance with an aspect of the present invention - each circuit branch must be equipped with a parallel bypass branch.

In a simulation, the inventive switchable power divider circuit in accordance with the embodiment of Fig. 1, an insertion loss of less than approximately 3.9 dB for both output ports, i.e., said second and third ports P2, P3 in Fig. 1, has been determined. This is a promising result in comparison to an insertion loss of 3 dB caused by an ideal Wilkinson divider. The simulated bandwidth was about 300 MHz ranging from approximately 700 MHz to approximately 1 GHz.

In single output mode the switchable power divider circuit 1 of Fig. 1 caused an insertion loss of less than 1 dB. All ports were matched with better than -5 dB, in most cases better than -10 dB.

As will further be appreciated by a person skilled in the art, the proposed switchable power divider circuit can also be used in reverse configuration, i.e., as an input combiner. For this usage (not shown in Fig. 1) respective input powers are provided at said second and third ports P2, P3, and a combined output power is delivered to said first port P1. Additionally it can be used to direct a signal either from port P2 or P3 to port P1 with losses < 1 dB, which is an improvement of 2 dB compared to a conventional power combiner with one of the two ports P2 or P3 terminated with an impedance of 50 Ω.

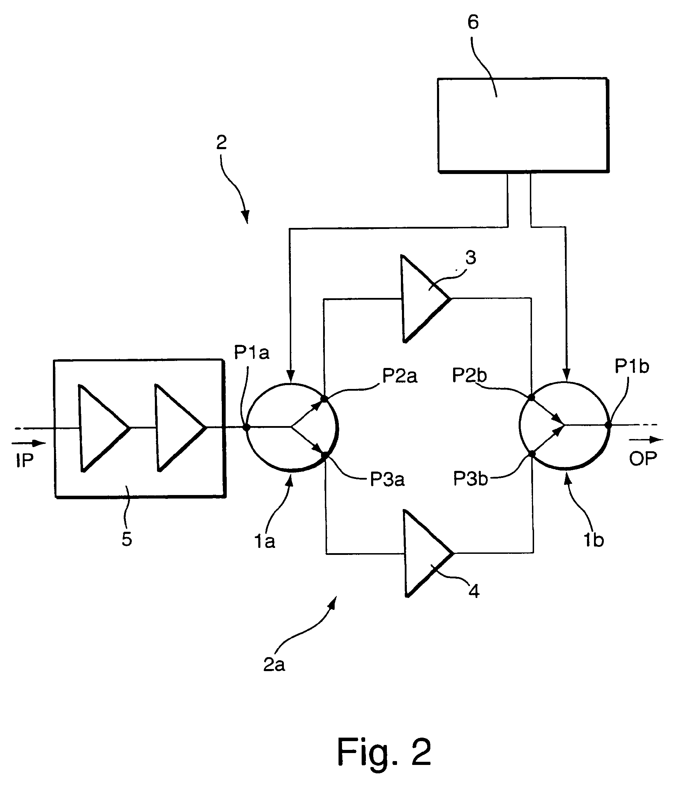

A preferred application of above-described switchable power divider/combiner circuit is related to realisation of a multi-standard amplifier module. An embodiment of such an amplifier module will now be described with reference with appended Fig. 2.

**Fig. 2** shows a block diagram of an embodiment of the power amplifier module in accordance with the present invention. The power amplifier module **2** of Fig. 2 comprises a first amplifying means **3** connected in parallel with a second amplifying means **4**. In the exemplary embodiment of Fig. 2, both of said first and second amplifying means 3, 4 are devised as power transistors, wherein said first amplifying means is an, e.g., 65 Watt power transistor, and said second amplifying means 4 is an, e.g., 140 Watt power transistor. Upstream of said first and second amplifying means 3, 4 there is located a first switchable power divider circuit **1a** as previously described with reference to appended Fig. 1. With its second port **P2a**, said first switchable power divider circuit 1a is connected with said first amplifying means 3. With its third port **P3a**, said first switchable power divider circuit 1a is connected with said second amplifying means 4. The first port **P1a** of said first switchable power divider circuit 1a is connected with pre- / driver amplifying means **5** which receive an input signal IP to be amplified. Amplifying means 3, 4 thus constitute a final amplifier stage **2a** of amplifier module 2.

Downstream of said first and second amplifying means 3, 4, there is located a second switchable power divider circuit **1b** as previously described with reference to appended Fig. 1. However, in contrast to said first switchable power divider circuit 1a of Fig. 2, said second switchable power divider circuit 1b is employed as a power combiner or power switch (inverse single output mode). To this end, said second and third ports **P2b**, **P3b**, respectively, of said second power divider circuit 1b are connected with an output of said first and second amplifying means 3, 4, respectively, for to combine (if 1a in divider mode) or switch (if 1a in single ended mode) respective output signals from said first and/or second amplifying means 3, 4 and to output a corresponding combined (if 1a in divider mode)/switched (if 1a in single ended mode) output power signal **OP** at a first port **P1b** of said second switchable power divider circuit 1b.

The multi-standard power amplifier module 2 of Fig. 2 further comprises control means 6 for controlling the first and second switchable power divider circuits 1a, 1b, i.e., the switching elements SW1-SW4 (Fig. 1) comprised therein with respect to a desired operation mode (divider mode/single output mode).

In this way, the above-described inventive switchable power divider circuit is placed at the input and at the output of the final amplifier stage 2a of multi-standard amplifier module 2. Said first and second amplifying means 3, 4 are devised in the form of matched and biased transistors, as known to a person skilled in the art. Said transistors are chosen with respect to the multiple standards supported by multi-standard power amplifier 2. In the present example, multi-standard power amplifier 2 is devised as a multi-standard module supporting multiple output powers of, e.g., 65 Watt for GSM (Peak-to-Average Ratio PAR = 0 dB), 65 Watt for EDGE (PAR = 3,3 dB, i.e., necessary peak output power 140 Watt), and 50 Watt for UMTS (PAR = 6 dB, clipped WCDMA signal, i.e., necessary peak output power 200 Watt) (cf. table in Background section).

In the case of GSM operation, only said first amplifying means 3 (65 Watt transistor) is used. To achieve this, respective first and second circuit branches B1, B2 and respective second bypass branches BP2 (cf. Fig. 1) of said first and second switchable power divider circuits 1a, 1b are switched off, as previously described with reference to appended Fig. 1. This is equivalent to saying that the path including said second amplifying means 4 (140 Watt transistor) in Fig. 2 is switched off. In this way, divider 1a and combiner 1b are working in single output mode. The entire input power is delivered via said first bypass branch BP1.

For amplifying EDGE signals with an average output power of 65 Watt, a peak power of 140 Watt is necessary due to increased PAR. In this case, only said second amplifying means 4 (140 Watt transistor) is used, and the first path including said first amplifying means 3 of Fig. 2 is switched off by operating both divider 1a and combiner 1b accordingly (single output mode). To achieve this, all transmission paths except for respective second bypass branches BP2 of divider 1a and combiner 1b are switched off.

In the third case, UMTS signals with PAR = 6 dB (clipped) require a peak output power of approximately 200 Watt. To achieve such output power, both the first and second amplifying means 3, 4 of amplifier stage 2a according to the embodiment of Fig. 2 have to be used. Switchable power divider circuit 1a is used in said first operation mode (divider mode) and is realised as an asymmetrical divider. The input power to divider 1a is divided with respect to different peak output power levels and power gain. In the present example, input power to divider 1a is divided with -1.6 dB to said second amplifying means 4 (140 Watt transistor) and with -4.98 dB to said first amplifying means 3 (65 Watt transistor) by suitably devising the phase-shifting means, e.g., in the form of asymmetrical quarter-wave lines with adapted widths/impedances (cf. R. E. Collin, "Foundations for Microwave Engineering", IEEE Press, 2001, pp. 442-450). Assuming identical power gain for both transistors, output combiner 1b can be designed in an identical fashion.

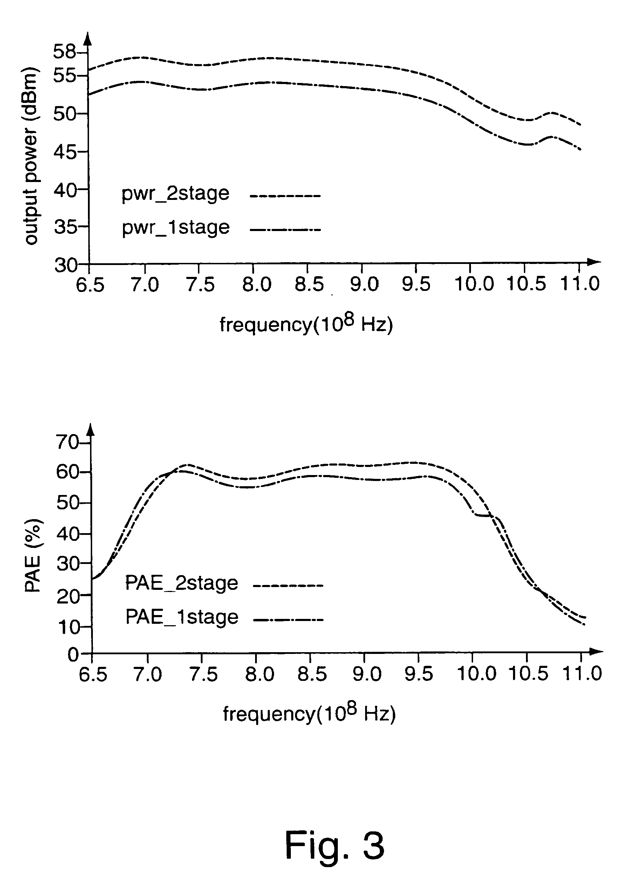

To validate the proposed approach (cf. Fig. 2), a simulation was performed with a symmetrical divider using two 135 Watt transistors as said first and second amplifying means 3, 4 (Fig. 1). Appended Fig. 3 shows the simulation results.

**Fig. 3** shows a diagram of the behaviour of a multi-standard power amplifier comprising the amplifier module 2 of Fig. 2 comprising said two 135 Watt transistors as first and second amplifying means 3, 4. By use of the proposed multi-band amplifier module according to the embodiment of Fig. 2, output power can be doubled by switching on the second 135 Watt transistor without loss of efficiency.

The upper panel of Fig. 3 shows an output power at 1 dB compression for the above-described multi-standard power amplifier as a function of frequency of the input signal. Output power unit is dBm, frequency unit is 10⁸ Hz. The upper curve (dashed; denoted "pwr_2stage") is for divider mode operation of power divider 1a (combiner 1b), and the lower curve (dash-dotted; denoted "pwr_1 stage") is for single output mode operation of said power divider 1a (power combiner 1b).

The lower panel of Fig. 3 shows a power amplifier efficiency at 1 dB compression as a functional frequency of the input signal. Power amplifier efficiency (PAE) is given in percent; frequency unit is again 10⁸ Hz. The dashed curve ("PAE_2stage") is for divider mode operation, whereas the dash-dotted curve ("PAE_1stage") is for single mode operation.

In the present, if power divider 1a of amplifier module 2 is operated in divider mode (both transistors active), a peak output power of approximately 57 dBm can be achieved over a wide bandwidth ranging from, e.g., 700 MHz to 950 MHz, with high efficiency of approximately 60%.

If power divider 1a is operated in switching mode (single output mode, i.e., only one transistor active), a reduced output power of approximately 54 dBm can be achieved over said bandwidth with equally high efficiency close to 60%.

As stated above, the results depicted in Fig. 3 are based on simulation and thus do not allow to derive any absolute and/or quantitative measure. In particular, thermal effects have not been included in the underlying modelling which results in an excessive output power of individual amplifying means (transistors).

In summary it can be stated that the proposed switchable power divider circuit in accordance with the present invention, which is based on double-sided RF-blocks, provides a promising possibility for realising multi-standard amplifier modules with high flexibility as far as adjustable output power levels are concerned, while achieving high efficiency for all power levels.

Additionally, as known to a person skilled in the art, biasing of the amplifying means (transistors) used in the amplifier module in accordance with the present invention can be adjusted in order to achieve further improvements with respect to output power and amplifier efficiency. Biasing of said amplifying means as well as controlling said first and second operation nodes of the switchable power divider circuit in accordance with the present invention (i.e., divider mode or single output mode) can be performed manually, by adaptive output power adaptation, or by means of a look-up table. For instance, said look-up table (not shown) could be provided in operative connection with control means 6 of Fig. 2. For adaptive output power adaptation, a suitable feedback path (not shown) could be provided at port P1b of power combiner 1b in Fig. 2, thus providing an output power feedback signal to control means 6 for adaptively controlling/biasing power divider 1a, power combiner 1b and said first and second amplifying means 3, 4, respectively.

## Claims

1. A power divider circuit (1) for a power amplifier module comprising:
- a first port (P1);
- at least one first circuit branch (B1) connecting said first port (P1) with a second port (P2);
- at least one second circuit branch (B2) connecting said first port (P1) with a third port (P3);
- first and second bypass branches (BP1, BP2) connected in parallel with said first and second circuit branches (B1, B2), respectively;
- said first bypass branch (BP1) connects said first port (P1) with said second port (P2), **characterised in that** said second bypass branch (BP2) connects said first port (P1) with said third port (P3);
- each of said first and second circuit branches (B1, B2) and each of said first and second bypass branches (BP1, BP2) comprises at least one respective switching element (SW1, SW2, SW3, SW4);
wherein said switching elements are adapted either for simultaneously activating said first circuit branch and said second circuit branch and for simultaneously deactivating said first and second bypass branches in a first operation mode, or for activating any one of said first and second bypass branches and for simultaneously deactivating said first and second circuit branches and the other one of said first and second bypass branches in a second operation mode.

2. The divider circuit (1) of claim 1, **characterised in that** said switching elements (SW1-SW4) are devised as diodes, in particular PIN diodes.

3. The divider circuit (1) of claim 1, **characterised in that** each one of said first and second circuit branches (B1, B2) and said first and second bypass branches (BP1, BP2) comprises at least one phase-shifting means (PS1-PS8), in particular a quarter-wave transformer.

4. The divider circuit (1) of claim 1, **characterised in that** each one of said first and second circuit branches (B1, B2) and said first and second bypass branches (BP1, BP2) comprises a first and a second phase-shifting means (PS1, PS2; PS3, PS4; PS5, PS6; PS7, PS8), in particular a quarter-wave transformer, wherein the switching element (SW1-SW4) for each branch is connected with a node (A1, A1', A2, A2') located between respective first and second phase-shifting means.

5. The divider circuit (1) of claim 1, **characterised in that** each switching element (SW1-SW4) is further connected with a respective blocking element (C1-C4), in particular a capacitor, for blocking a biasing potential of said switching element.

6. A power amplifier module (2) comprising at least two amplifying means (3, 4), **characterised by** at least one switchable power divider circuit (1 a) according to any one of claims 1 to 5, wherein a first one of said amplifying means (3) is connected with said second port (P2a) of the divider circuit (1a), and wherein a second one of said amplifying means (4) is connected with said third port (P3a) of the divider circuit (1 a).

7. The power amplifier module (2) of claim 6, **characterised by** a second switchable power divider circuit (1 b) according to any one of claims 1 to 5, wherein said first one of said amplifying means (3) is further connected with said second port (P2b) of the second divider circuit (1 b), and wherein said second one of said amplifying means (4) is further connected with said third port (P3b) of the second divider circuit (1 b).

8. Transmitter for multi-standard transmission, comprising at least one amplifier module (2) according to claim 6 or 7.

9. Base station for multi-standard communication comprising at least one transmitter according to claim 8.

10. Mobile station for multi-standard communication comprising at least one transmitter according to claim 8.

## Patentansprüche

1. Leistungsteilerschaltung (1) für ein Leistungsverstärkermodul, umfassend:
- Einen ersten Port (P1);
- mindestens einen ersten Schaltungszweig (B1), welcher den besagten ersten Port (P1) mit einem zweiten Port (P2) verbindet;
- mindestens einen zweiten Schaltungszweig (B2), welcher den besagten ersten Port (P1) mit einem dritten Port (P3) verbindet;
- einen ersten und einen zweiten Überbrückungszweig (BP1, BP2) welche jeweils parallel mit dem besagten ersten und dem besagten zweiten Schaltungszweig (B1, B2) verbunden sind;
- wobei der besagte erste Überbrückungszweig (BP1) den besagten ersten Port (P1) mit dem besagten zweiten Port (P2) verbindet, **dadurch gekennzeichnet, dass** der besagte zweite Überbrückungszweig (BP2) den besagten ersten Port (P1) mit dem besagten dritten Port (P3) verbindet;
- wobei sowohl der besagte erste als auch der besagte zweite Schaltungszweig (B1, B2) und sowohl der besagte erste als auch der besagte zweite Überbrückungszweig (BP1, BP2) mindestens ein entsprechendes Schaltelement (SW1, SW2, SW3, SW4) umfasst;
wobei die besagten Schaltelemente entweder für die simultane Aktivierung des besagten ersten Schaltungszweigs und des besagten zweiten Schaltungszweigs und für die simultane Deaktivierung des besagten ersten und des besagten zweiten Überbrückungszweigs in einem ersten Betriebsmodus, oder für die Aktivierung eines beliebigen des besagten ersten und des besagten zweiten Überbrückungszweigs und für die simultane Deaktivierung des besagten ersten und des besagten zweiten Überbrückungszweigs und des anderen des besagten ersten und des besagten zweiten Überbrückungszweigs in einem zweiten Betriebsmodus ausgelegt sind.

2. Leistungsteilerschaltung (1) nach Anspruch 1, **dadurch gekennzeichnet, dass** die besagten Schaltelemente (SW1-SW4) als Dioden, insbesondere als PIN-Dioden, ausgebildet sind.

3. Leistungsteilerschaltung (1) nach Anspruch 1, **dadurch gekennzeichnet, dass** sowohl der besagte erste als auch der besagte zweite Schaltungszweig (B1, B2) und sowohl der besage erste als auch der besagte zweite Überbrückungszweig (BP1, BP2) mindestens ein Phasenverschiebungsmittel (PS1-PS8), insbesondere einen Viertelwellen-Transformator, umfasst.

4. Leistungsteilerschaltung (1) nach Anspruch 1, **dadurch gekennzeichnet, dass** sowohl der besagte als auch der besagte zweite Schaltungszweig (B1, B2) und sowohl der besagte erste als auch der besagte Überbrückungszweig (BP1, BP2) ein erstes und ein zweites Phasenverschiebungsmittel (PS1, PS2; PS3, PS4; PS5, PS6; PS7, PS8), insbesondere einen Viertelwellen-Transformator, umfasst, wobei das Schaltelement (SW1-SW4) für jeden Zweig mit einem zwischen den jeweiligen ersten und zweiten Phasenverschiebungsmitteln angeordneten Knoten (A1, A1', A2, A2') verbunden ist.

5. Leistungsteilerschaltung (1) nach Anspruch 1, **dadurch gekennzeichnet, dass** jedes Schaltelement (SW1-SW4) weiterhin mit einem entsprechenden Abblockelement (C1-C4), insbesondere einem Kondensator, zum Abblocken einer Vorspannung des besagten Schaltelements verbunden ist.

6. Leistungsverstärkermodul (2) mit mindestens zwei Verstärkungsmitteln (3, 4), **gekennzeichnet durch** mindestens einen schaltbaren Leistungsteiler (1 a) nach einem beliebigen der Ansprüche 1 bis 5, wobei ein erstes der besagten Verstärkungsmittel (3) mit dem besagten zweiten Port (P2a) der Teilerschaltung (1 a) verbunden ist, und wobei ein zweites der besagten Verstärkungsmittel (4) mit dem besagten dritten Port (P3a) der Teilerschaltung (1 a) verbunden ist.

7. Leistungsverstärkermodul (2) nach Anspruch 6, **gekennzeichnet durch** einen zweiten schaltbaren Leistungsteiler (1 b) nach einem beliebigen der Ansprüche 1 bis 5, wobei das besagte erste der besagten Verstärkungsmittel (3) weiterhin mit dem besagten zweiten Port (P2b) der zweiten Teilerschaltung (1 b) verbunden ist, und wobei das besagte zweite der besagten Verstärkungsmittel (4) weiterhin mit dem besagten dritten Port (P3b) der zweiten Teilerschaltung (1 b) verbunden ist.

8. Sender für Multistandard-Übertragungen mit mindestens einem Verstärkermodul (2) gemäß Anspruch 6 oder 7.

9. Basisstation für Multistandard-Kommunikation mit mindestens einem Sender gemäß Anspruch 8.

10. Mobilstation für Multistandard-Kommunikation mit mindestens einem Sender gemäß Anspruch 8.

## Revendications

1. Circuit diviseur de puissance (1) pour un module amplificateur de puissance, comprenant :
- un premier port (P1) ;
- au moins une première branche de circuit (B1) reliant ledit premier port (P1) à un deuxième port (P2) ;
- au moins une deuxième branche de circuit (B2) reliant ledit premier port (P1) à un troisième port (P3) ;
- des première et deuxième branches de dérivation (BP1, BP2) reliées en parallèle auxdites première et deuxième branches de circuit (B1, B2), respectivement ;
- ladite première branche de dérivation (BP1) relie ledit premier port (P1) audit deuxième port (P2), **caractérisé en ce que** ladite deuxième branche de dérivation (BP2) relie ledit premier port (P1) audit troisième port (P3) ;
- chacune desdites première et deuxième branches de circuit (B1, B2) et chacune desdites première et deuxième branches de dérivation (BP1, BP2) comprend au moins un élément de commutation (SW1, SW2, SW3, SW4) respectif ;
dans lequel lesdits éléments de commutation sont adaptés pour activer simultanément ladite première branche de circuit et ladite deuxième branche de circuit et pour désactiver simultanément lesdites première et deuxième branches de dérivation dans un premier mode de fonctionnement, ou pour activer l'une quelconque desdites première et deuxième branches de dérivation et pour désactiver simultanément lesdites première et deuxième branches de circuit et l'autre parmi lesdites première et deuxième branches de dérivation dans un deuxième mode de fonctionnement.

2. Circuit diviseur (1) selon la revendication 1, **caractérisé en ce que** lesdits éléments de commutation (SW1 à SW4) sont conçus sous forme de diodes, en particulier de diodes PIN.

3. Circuit diviseur (1) selon la revendication 1, **caractérisé en ce que** chacune desdites première et deuxième branches de circuit (B1, B2) et desdites première et deuxième branches de dérivation (BP1, BP2) comprend au moins un moyen de déphasage (PS1 à PS8), en particulier un transformateur quart d'onde.

4. Circuit diviseur (1) selon la revendication 1, **caractérisé en ce que** chacune desdites première et deuxième branches de circuit (B1, B2) et desdites première et deuxième branches de dérivation (BP1, BP2) comprend un premier et un deuxième moyens de déphasage (PS1, PS2; PS3, PS4; PS5, PS6; PS7, PS8), en particulier un transformateur quart d'onde, dans lequel l'élément de commutation (SW1 à SW4) pour chaque branche est relié à un noeud (A1, A1', A2, A2') situé entre les premier et deuxième moyens de déphasage respectifs.

5. Circuit diviseur (1) selon la revendication 1, **caractérisé en ce que** chaque élément de commutation (SW1 à SW4) est en outre relié à un élément de blocage (C1 à C4) respectif, en particulier un condensateur, pour bloquer un potentiel de polarisation dudit élément de commutation.

6. Module amplificateur de puissance (2) comprenant au moins deux moyens d'amplification (3, 4), **caractérisé par** au moins un circuit diviseur de puissance (1a) commutable selon l'une quelconque des revendications 1 à 5, dans lequel un premier desdits moyens d'amplification (3) est relié audit deuxième port (P2a) du circuit diviseur (1a), et dans lequel un deuxième desdits moyens d'amplification (4) est relié audit troisième port (P3a) du circuit diviseur (1 a).

7. Module amplificateur de puissance (2) selon la revendication 6, **caractérisé par** un deuxième circuit diviseur de puissance (1 b) commutable selon l'une quelconque des revendications 1 à 5, dans lequel ledit premier desdits moyens d'amplification (3) est en outre relié audit deuxième port (P2b) du deuxième circuit diviseur (1b), et dans lequel ledit deuxième desdits moyens d'amplification (4) est en outre relié audit troisième port (P3b) du deuxième circuit diviseur (1 b).

8. Émetteur pour une transmission multi-standard, comprenant au moins un module amplificateur (2) selon la revendication 6 ou 7.

9. Station de base pour une communication multi-standard comprenant au moins un émetteur selon la revendication 8.

10. Station mobile pour une communication multi-standard comprenant au moins un émetteur selon la revendication 8.
